# EUROPÄISCHE PATENTSCHRIFT

(11) **EP 1 250 762 B1**
(45) Veröffentlichungstag und Bekanntmachung des Hinweises auf die Patenterteilung: **02.03.2005**
(21) Anmeldenummer: 00991570.3
(22) Anmeldetag: 21.12.2000
(51) Int. Cl.: H03M 1/46

(54) **ANALOG-DIGITAL-WANDLER**
ANALOG-TO-DIGITAL CONVERTER
CONVERTISSEUR ANALOGIQUE-NUMERIQUE

(30) Priorität: 28.01.2000 DE 10003701
(43) Veröffentlichungstag der Anmeldung: 23.10.2002
(73) Patentinhaber: Infineon Technologies AG, 81669 München (DE)
(72) Erfinder: SCHMID, Harald, A-9523 Villach (AT)
(74) Vertreter: Repkow, Ines, Dr. Dipl.-Ing.
(86) Internationale Anmeldenummer: PCT/DE2000/004638
(87) Internationale Veröffentlichungsnummer: WO 2001/056165

(56) Entgegenhaltungen:
- US-A- 3 781 871
- US-A- 4 314 235
- D. MERCER ET AL.: "8-bit a-d converter mater transducers with <mu>Ps" ELECTRONIC DESIGN., Bd. 32, Nr. 1, Januar 1984 (1984-01), Seiten 361-367, XP002176160 PENTON PUBLISHING, CLEVELAND, OH., US ISSN: 0013-4872

## Beschreibung

Die Erfindung betrifft einen Analog-Digital-Wandler zur sukzessiv approximierenden Umwandlung eines analogen Eingangssignals in ein digitales Ausgangssignal mit erhöhter Wandlungsrate.

Analog-Digital-Wandler sind elektronische Schaltungen, die ein analoges Eingangssignal in ein digitales Ausgangssignal umwandeln. Beim Verfahren der sukzessiven Approximation werden die Datenbits des digitalen Ausgangssignals in Wägeschritten sukzessive nacheinander bestimmt. Hierzu erhält der Analog-Digital-Wandler einen Komparator, einen Digital-Analog-Wandler DAC, einen sukzessive Approximationsregister SAR, sowie eine Logikschaltung. Beim Verfahren der sukzessiven Approximation wird zunächst das höchstwertige Bit MSB gesetzt und dann mit dem Digital-Analog-Wandler DAC der zugehörige Wert einer Analogspannung ermittelt. Ist die zu wandelnde Eingangsanalogspannung größer als die ermittelte Ausgangsanalogspannung des Digital-Analog-Wandlers DAC, dann bleibt das gesetzte Bit gesetzt und im umgekehrten Falle wird es wieder zurückgesetzt. Nun wird das nächst niederwertige Bit gesetzt und aus dem entsprechenden digitalen Wert mit dem Digital-Analog-Wandler DAC die dazugehörige analoge Ausgangsspannung erzeugt. Die so gebildete analoge Ausgangsspannung wird mit der zu wandelnden analogen Eingangsspannung verglichen und danach mittels des Komparators entschieden, ob das gesetzte Bit gesetzt bleiben kann oder nicht. Auf diese Weise wird das Verfahren fortgesetzt, bis sukzessive alle Bits des binär kodierten Digital-Analog-Wandlers ermittelt worden sind. Die Umwandlungsrate bzw. Konversionsrate hängt bei derartig
Analog-Digital-Wandlern nach dem Stand der Technik in erster Linie von der Geschwindigkeit des Komparators ab. Der Komparator ist mehrstufig aufgebaut. Der Komparator enthält in der Regel mindestens eine lineare Eingangsstufe zur linearen Verstärkung eines analogen Eingangssignals mit einer relativ niedrigen Verstärkung sowie mindestens eine Ausgangsstufe mit einer relativ hohen Verstärkung.

Die zeitlichen Schranken, die im wesentlichen die Konversionsrate des Analog-Digital-Wandlers bestimmen, sind einerseits durch die Erholzeit bzw. Recoverytime des Komparators nach einer Übersteuerung der linearen Eingangstufe und andererseits durch die minimale Schaltzeit des Komparators bei kleiner Aussteuerung vorgegeben.

Da die Datenbits des digital gewandelten Wertes sukzessive ermittelt werden, ist die Konversionsrate im Vergleich zu einem Parallelwandler geringer und eine Geschwindigkeitserhöhung bzw. eine Erhöhung der Konversionsrate ist bei einem Analog-Digital-Wandler mit sukzessive Approximation besonders wünschenswert.

Es ist daher die Aufgabe, der vorliegenden Erfindung einen Analog-Digital-Wandler zur sukzessiv approximierenden Umwandlung eines analogen Eingangssignals in ein digitales Ausgangssignal mit einer erhöhten Konversionsrate zu schaffen.

Diese Aufgabe wird erfindungsgemäß durch einen Analog-Digital-Wandler mit den im Patentanspruch 1 angegebenen Merkmalen gelöst.

Die Erfindung schafft einen Analog-Digital-Wandler zur sukzessiv approximierenden Umwandlung eines analogen Eingangssignals in ein digitales Ausgangssignal mit
einem aus mindestens einer linearen Eingangsstufe und einer Ausgangsstufe bestehenden Komparator, der das analoge Eingangssignal mit einem, von einem Digital-Analog-Wandler abgegebenen analogen Vergleichssignal vergleicht und ein Komparator-Ausgangssignal zum Einstellen eines getakteten sukzessiven Approximationsregisters abgibt, wobei der in dem Approximationsregister zwischengespeicherte digitale Wert durch den Digital-Analog-Wandler zu dem analogen Vergleichssignal gewandelt wird, und mit
einer Beschleunigungsschaltung, die ein umschaltbares Taktsignal an das getaktete sukzessive Approximationsregister in Abhängigkeit von mindestens einem Übersteuerungs-Anzeigesignal abgibt, das eine Übersteuerung einer zugehörigen linearen Eingangsstufe in dem Komparator anzeigt.

Die dem erfindungsgemäßen Analog-Digital-Wandler zugrunde liegende Idee besteht darin, die Übersteuerung der linearen Eingangsstufen des Komparators zu erfassen und in Abhängigkeit davon das sukzessive Approximationsregister zu takten.

Die Erfassung der Übersteuerung muss dabei nicht unbedingt sehr genau erfolgen.

Bei einer bevorzugten Ausführungsform des erfindungsgemäß Analog-Digital-Wandlers enthält die lineare Eingangsstufe, eine Differenz-Verstärker-Schaltung und eine Übersteuerungs-Erfassungsschaltung zur Erfassung der Übersteuerung der Differenz-Verstärker-Schaltung.

Bei einer besonders bevorzugten Ausführungsform ist die Übersteuerungserfassungsschaltung ein Fensterdiskriminator.

Die Beschleunigungsschaltung ist vorzugsweise eingangsseitig mit einem Taktgenerator verbunden.

Bei einer weiteren bevorzugten Ausführungsform weist die Beschleunigungsschaltung einen Impulsgenerator auf, dem ausgangsseitig ein erstes Laufzeitglied zur Verzögerung des erzeugten Impulses um die Erholzeit des Komparators und ein zweites Laufzeitglied zur Verzögerung des erzeugten Impulses um die maximale Entscheidungszeit des Komparators nachgeschaltet sind, wobei die Signalausgänge der beiden Laufzeitglieder mit einer gesteuerten Schalteinrichtung verbunden sind, die die Signalausgänge der Laufzeitglieder in Abhängigkeit von dem Übersteuerungs-Anzeigesignal an das sukzessive Approximationsregister durchschaltet.
Die Schalteinrichtung ist vorzugsweise ein Multiplexer.

Der Impulsgenerator ist dabei vorzugsweise ein Flip-Flop. Dabei ist der Ausgang des Multiplexers vorzugsweise an das Flip-Flop gekoppelt.

Der Impulsgenerator und die Laufzeitglieder werden vorzugsweise synchron durch den Taktgenerator getaktet.

Das sukzessive Approximationsregister ist vorzugsweise mit einem Ausleseregister zum Auslesen des digitalisierten Endwertes verbunden.

Die Übersteuerungserfassungsschaltung erfasst vorzugsweise die Höhe und das Vorzeichen der Übersteuerung des Differenzverstärkers.
Bei einer weiteren bevorzugten Ausführungsform ist das Taktsignal durch die Beschleunigungsschaltung zwischen einem ersten Taktsignal mit einer minimalen Taktperiode und einem zweiten Taktsignal mit einer maximalen Taktperiode umschaltbar.

Bei einer bevorzugten Ausführungsform entspricht die minimale Taktperiode der Erholungszeit des Komparators und die maximale Taktperiode der maximalen notwendigen Entscheidungszeit des Komparators.

Bei einer besonders bevorzugten Ausführungsform ist die minimale Taktperiode als Laufzeit des ersten Laufzeitgliedes und die maximale Taktperiode als Laufzeit der beiden Laufzeitglieder extern einstellbar.

Die Erfindung schafft ferner ein Verfahren zur Umwandlung eines analogen Eingangssignals in ein digitales Ausgangssignal mit den folgenden Schritten:
(a) Vergleichen des analogen Eingangssignals mit einem analogen Vergleichsignal, das einem in einem getakteten sukzessiven Appproximationsregister zwischengespeicherten Digitalwert entspricht, durch einen Komparator;
(b) Bilden eines Komparatorausgangssignals in Abhängigkeit von dem Vergleichsergebnis zur Einstellung des zwischengespeicherten Digitalwertes in dem sukuzessive Approximationsregister;
(c) Erfassen, ob eine lineare Eingangsstufe des Komparators übersteuert ist;
(d) Umschalten eines Taktsignals für das getaktete sukzessive Approximationsregister auf ein erstes Taktsignal mit einer minimalen Taktperiode, wenn eine Übersteuerung erfasst wird, und auf ein zweites Taktsignal mit einer maximalen Taktperiode, wenn keine Übersteuerung erfasst wird.

Im weiteren werden bevorzugte Ausführungsformen des erfindungsgemäßen Analog-Digital-Wandlers, sowie des erfindungsgemäßen Umwandlungsverfahrens unter Bezugnahme auf die beigefügten Zeichnungen zur Erläuterung erfindungswesentlicher Merkmale beschrieben.

Es zeigen:
- Figur 1: Ein Blockschaltbild einer bevorzugten Ausführungsform des erfindungsgemäßen Analog-Digital-Wandlers;
- Figur 2: Ein Schaltkreisdiagramm einer Erfindungsstufe des in dem erfindungsgemäßen Analog-Digital-Wandlers enthaltenen Komparators ;
- Figur 3: Eine bevorzugte Ausführungsform der in dem erfindungsgemäßen Analog-Digital-Wandler enthaltenen Beschleunigungsschaltung;
- Figur 4: Ein einfaches Ablaufdiagramm zur Erläuterung des erfindungsgemäßen Verfahrens zur Umwandlung eines analogen Signals in ein digitales Ausgangssignal.

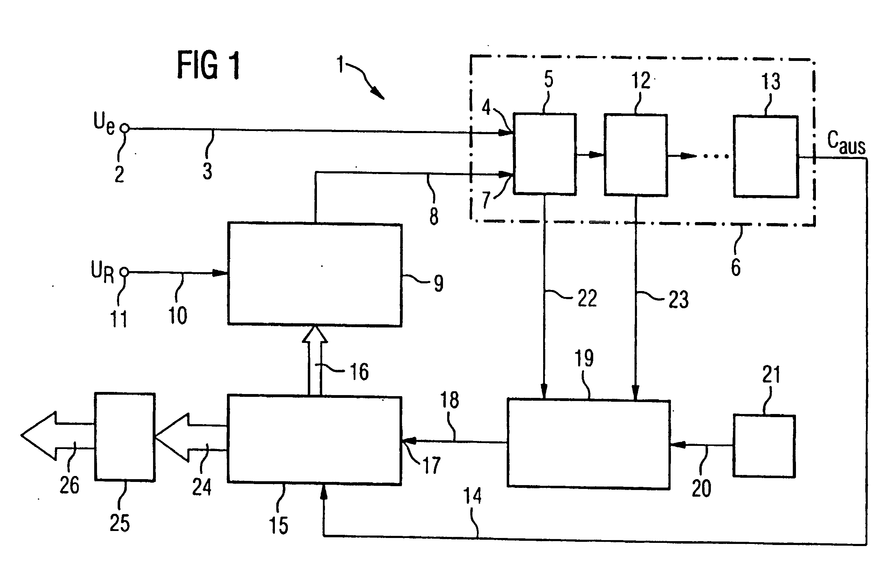

Figur 1 zeigt ein Blockschaltbild des erfindungsgemäßen Analog-Digital-Wandlers zur sukzessiv approximierenden Umwandlung eines Analogeingangssignals in ein digitales Ausgangssignal.

Der erfindungsgemäße Analog-Digital-Wandler 1 weist einen analogen Eingangsanschluss 2 zum Anlegen des zu wandelnden analogen Eingangssignals auf. Der analoge Eingangssignalanschluss 2 ist über eine Leitung 3 mit einem ersten Eingang 4 einer analogen Eingangsstufe 5 eines Komparators 6 verbunden. Die analoge erste Eingangsstufe 5 des Komparators 6 weist einen zweiten analogen Eingang 7 auf, der über eine Signalleitung 8 mit einem Digital-Analog-Wandler 9 verbunden ist. Der Digital-Analog-Wandler 9 erhält über eine Leitung 10 und einen Referenzspannungsanschluss 11 eine Referenzspannung U_{R} zur Durchführung der Digital-Analog-Wandlung. Der Komparator 6 weist mehrere hintereinander geschaltete Verstärkungsstufen 5,6, 12 sowie mindestens eine Ausgangsstufe 13 zur Verstärkung des Komparatorausgangssignals Cₐᵤₛ auf. Das Komparatorausgangssignal Cₐᵤₛ wird über eine Signalleitung 14 in ein getaktetes sukzessives Approximationsregister 15 eingeschrieben. Der in das sukzessive Approximationsregister 15 eingeschriebene digitale Wert gelangt über Datenleitungen 16 zu dem Digitalanalogwandler 9, der den in dem sukzessiven Approximationsregister 15 enthaltenen digitalen Wert in eine Analogspannung umwandelt, die über die analoge Signalleitung 8 an den Eingang 7 der ersten linearen Verstärkungsstufe 5 des Komparators 6 gelegt wird.

Das sukzessive Approximationsregister 15 weist einen Takteingang 17 auf, der über eine Taktleitung 18 mit einer Beschleunigungsschaltung 19 verbunden ist. Die Beschleunigungsschaltung 19 ist eingangsseitig über eine Taktleitung 20 mit einem Taktgenerator 21 verbunden. Darüber hinaus hält die Beschleunigungsschaltung über Steuerungsanzeige-Signalleitungen 22, 23 über Steuerungsanzeigesignale von den linearen Eingangsstufen 5, 12 des Komparators 6. Die Übersteuerungsanzeigesignale zeigen eine Übersteuerung der zugehörigen linearen Eingangstufe 5, 12 in dem Komparator 6 an.

Der in dem sukzessiven Approximationsregister 15 enthaltene digitale Wert wird nach erfolgter Analogdigitalwandlung über digitale Ausleseleitungen 24 in ein Ausleseregister 25 eingeschrieben. Der in dem Ausleseregister 25 befindliche gewan- . delte Ausgangswert kann dann über Ausleseleitungen 26 ausgelesen werden. Der ausgelesene digitale Wert entspricht dabei dem analogen Eingangssignal U_{E} .

Die Umwandlungsrate bzw. Konversionsrate des in Figur 1 dargestellten Analog-Digital-Wandlers 1 hängt in erster Linie von der Geschwindigkeit des Komparators 6 ab. Bei geringer Aussteuerung der linearen Eingangsstufen 5,12 kann der Komparator 6 innerhalb einer Entscheidungsschaltzeit die Entscheidung treffen, ob das zuletzt in dem sukzessiven Approximationsregister 9 gesetzte Bit gesetzt bleibt oder wieder zurückgesetzt wird.

Bei einer großen Aussteuerung der ersten linearen Eingangsstufe 5 bzw. der linearen Eingangsstufen 5, 12 des Komparators 6 muss jedoch nicht die gesamte Entscheidungsschaltzeit des Komparators 6 abgewartet werden, sondern die Entscheidung kann bereits ausgewertet werden, sobald die Übersteuerung eine Eingangsstufe des Komparators 6 dedektiert wird. Bei einer großen Aussteuerung der linearen Eingangsstufe 5, d.h. bei einer großen Differenzspannung zwischen den Eingangsanschlüssen 4, 7 der linearen Eingangsstufe 5 ist die lineare Eingangsstufe 5 bereits nach sehr kurzer Zeit übersteuert.
Ist eine der vorderen linearen Eingangsstufen 5, 12 des Komparators 6 übersteuert, so kann das Komparatorausgangssignal sofort ausgewertet werden und der nächste Wägeschritt bzw. Approximationsschritt durchgeführt werden. Bei einer Übersteuerung der linearen Eingangsstufe 5, 12 kann die Zeitspanne für die Entscheidung durch den Komparator 6 auf die Erholzeit bzw. Recoverytime nach einer Übersteuerung und einer evtl. zusätzlich kurzen Sicherheitszeit verkürzt werden.

Die Übersteuerung der linearen Eingangsstufe 5, 12 des Komparators 6 geschieht durch eine in den linearen Eingangsstufen integrierte Übersteuerungserfassungsschaltung, die ausgangsseitig über die Übersteuerungserfassungsleitungen 22,23 jeweils ein Übersteuerungsanzeigesignal an die Beschleunigungsschaltung 19 abgeben. Die Beschleunigungsschaltung 19 taktet über die Taktleitung 18 des sukzessive Approximationsregister 15. Die Beschleunigungsschaltung 19 ist eingangsseitig über die Taktleitung 20 mit einem Taktgenerator 21 verbunden. Erhält die Beschleunigungsschaltung 19 über die Übersteuerungsanzeigesignalleitungen 22, 23 Übersteuerungs-anzeigesignal, bei welcher eine Übersteuerung zugehöriger linearer Eingangsstufen 5, 12 in dem Komparator 6 anzeigen, wird die Taktfrequenz des an der Taktleitung 18 anliegenden Taktsignals zum Takten des sukzessiven Approximationsregisters 15 erhöht. In diesem Falle wird lediglich die Erholungszeit nach einer Übersteuerung abgewartet.

Erhält die Beschleunigungsschaltung 19 umgekehrt keine Übersteuerungsanzeigesignale über die Leitungen 22, 23 von den linearen Eingangsstufen 5, 12 des Komparators 6, wird durch die Beschleunigungsschaltung 19 an der Taktzeitung 18 ein Taktsignal mit einer relativ niedrigen Taktfrequenz zum Takten des sukzessiven Approximationsregisters 15 angelegt Diese relativ niedrige Taktfrequenz entspricht der notwendigen maximalen Entscheidungszeit des Komparators 6.

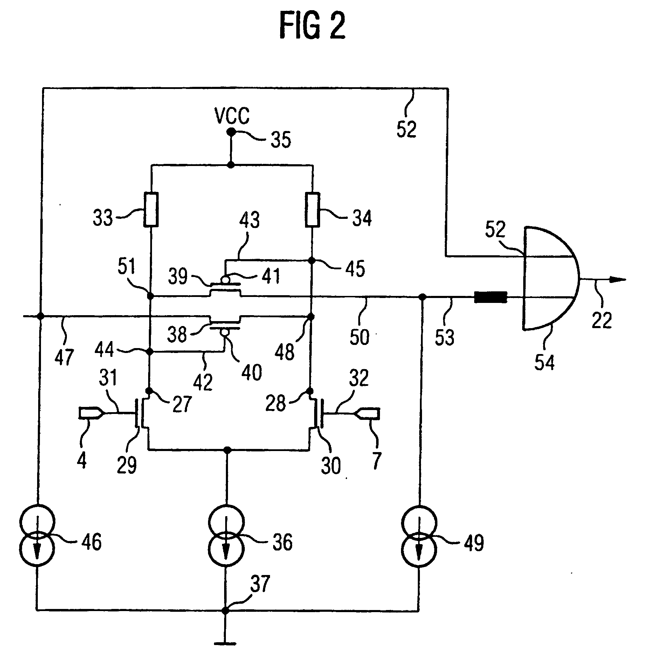

Figur 2 zeigt eine lineare Eingangsstufe 5,12, des Komparators 6 bei dem erfindungsgemäßen Analog-Digital-Wandler 1, wie er in Figur 1 dargestellt ist.

Die lineare Eingangsstufe 5 enthält eine Differenzverstärkerschaltung und eine Übersteuerungserfassungsschaltung zur Erfassung einer Übersteuerung der Differenzverstärkerschaltung. Die Differenzverstärkerschaltung besteht aus zwei Differenzverstärkertransistoren, 27, 28 deren Gateanschlüsse 29,30 über Leitungen 31, 32 mit den beiden analogen Signaleingängen 4, 7 der linearen Eingangsverstärkerstufe 5 des Komparators 6 verbunden sind. Die Differenztransistoren 27,28 sind dabei vorzugsweise MOSFET-Transistoren. Die Differenztransistoren 27, 28 sind Reihe zu Lastwiderständen 33,34 geschaltet, die an einem Versorgungsspannungsanschluss 35 anliegen. Darüber hinaus enthält die Differenzverstärkerschaltung eine Differenzverstärkerstromquelle 36, die bei durchgeschaltetem Differenztransistor 27, 28 den zugehörigen Lastwiderstand 33,34 auf einen Masseanschluss 37 zieht.

Zusätzlich enthält die in Figur 2 dargestellte lineare Eingangsstufe 5 eine an die Differenzverstärkerschaltung angeschlossene Übersteuerungserfassungsschaltung. Die Übersteuerungserfassungsschaltung umfasst Erfassungstransistoren 38, 39, deren Gateanschlüsse 40, 41 über Leitungen 42, 43 an Abzweigepotentialknoten 44, 45 zwischen einem Lastwiderstand 33, 34 und dem zugehörigen Differenzverstärker 27, 28 anliegen. Die Erfassungstransistoren 38, 39 sind bei der in Figur 2 dargestellten Ausführungsform jeweils P-Kanal-MOSFETS. Ferner enthält die Übersteuerungserfassungsschaltung eine Stromquelle 46, die über eine Leitung 47 und den Erfassungstransistor 38 mit einem Abzweigungspotentialknoten 48 zwischen dem Lastwiderstand 34 und dem Differenztransistor 28 angeschlossen ist. Symmetrisch dazu ist eine weitere Stromquelle 49 Übersteuerungserfassungsschaltung vorgesehen, die über eine Leitung 50 über den Erfassungstransistor 39 mit einem Abzweigungspotentialknoten 51, der zwischen dem Lastwiderstand 33 und dem Differenztransistor 27 liegt, verbunden ist.

Sobald das Differenzspannungssignal zwischen den analogen Signaleingängen 4, 7 der Differenzverstärkerschaltung einen gewissen vorgegebenen Schwellenwert überschreitet, schaltet einer der beiden Erfassungstransistoren 38, 39 je nach Vorzeichen der Übersteuerung durch. Hierdurch wird der Strompfad von dem Spannungsversorgungsanschluss 35, über den Lastwiderstand 33 und die Stromquelle 49 zu dem Masseanschluss 37 oder der Strompfad von dem Spannungsversorgungsanschluss 35, über den Lastwiderstand 34, die Stromquelle 46 zu dem Masseanschluss 37 geöffnet. Das Durchschalten des Erfassungstransistors 38 wird über eine Leitung 52 und das Durchschalten des Erfassungstransistors wird über eine Leitung 53 erfasst. Die beiden Leitungen 52, 53 werden in einem Oder-Gatter 54 logisch Oder- verknüpft, das über die Übersteuerungsanzeigeleitung 22 ein Übersteuerungsanzeige-signal, welches die Übersteuerung der linearen Eingangsstufe anzeigt, an die Beschleunigungsschaltung 19 abgibt. Sobald die Übersteuerung der linearen Eingangsstufe einen bestimmten Stellenwert überschreitet, wird über die Leitung 22 ein Übersteuerungsanzeigesignal an die Beschleunigungsschaltung 19 abgegeben.

Die in Figur 2 dargestellte Übersteuerungserfassungsschaltung arbeitet als Fensterdiskriminator, wodurch die Erfassung der Übersteuerung besonders schnell erfolgt.

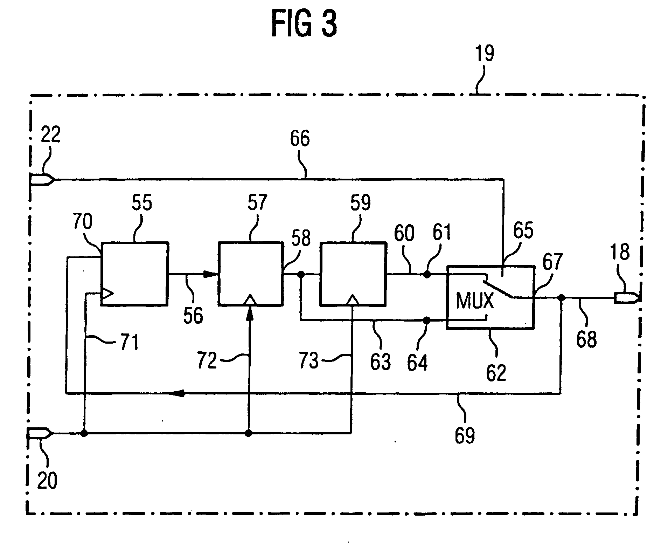

Figur 3 zeigt eine bevorzugte Ausführungsform der Beschleunigungsschaltung 19 des erfindungsgemäßen Analog-Digital-Wandlers 1. Die Beschleunigungsschaltung 19 enthält einen Impulsgenerator 55, der ausgangsseitig über eine interne Leitung 56 mit einem ersten Laufzeitglied 57 verbunden ist. Zu dem ersten Laufzeitglied ist über eine interne Leitung 58 ein zweites Laufzeitglied 59 in Serie geschaltet. Das Laufzeitglied 59 ist über eine Leitung 60 mit dem ersten Eingang 61 einer Schalteinrichtung 62 verbunden. Die Verbindungsleitung 58 zwischen dem ersten Laufzeitglied 57 und dem zweiten Laufzeitglied 59 ist über eine Leitung 63 mit einem zweiten Eingang 64 der Schalteinrichtung 62 verbunden.
Die Schalteinrichtung 62 weist einen Steueranschluss 65 auf, der das Umschalten zwischen dem ersten Eingang 62 und dem zweiten Eingang 62 der Schalteinrichtung 62 steuert. Der Steueranschluss 65 ist über eine Steuerleitung 66 mit der Übersteuerungsanzeigesignalleitung 22 verbunden. Die Schalteinrichtung 62 ist vorzugsweise ein Multiplexer, dessen Ausgang 67 über eine Leitung 68 mit der Taktsignalleitung 18 verbunden ist, die das analoge sukzessive Approximationsregister 15 mit einem Taktsignal versorgt. Der Ausgang 67 des Multiplexers 62 ist ferner über eine Rückkoppelleitung 69 mit einem Eingang 70 des Impulsgenerators 55 verbunden. Der Impulsgenerator 55 und die beiden Laufzeitglieder 57,59 werden synchron über Taktleitungen 71, 72, 73 getaktet, die über die Taktleitung 20 mit dem Taktgenerator 21 verbunden sind. Bei dem Impulsgenerator 55 handelt es sich bspw. um ein D-Flip-Flop Handeln, dessen Steuereingang 70 über die Rückkoppelleitung in den Ausgang 67 des Multiplexers angeschlossen ist. Das erste Laufzeitglied 57 verzögert den durch den Impulsgenerator 55 erzeugten Impuls um eine Zeit, die der Erholzeit des Komparators 6 gegenüber einer Übersteuerung entspricht.

Das zweite Laufzeitglied 59 verzögert den durch den Impulsgenerator 55 erzeugten Impuls dann zusätzlich soweit, dass die Laufzeitverzögerung der Entscheidungszeit des Komparators 6 entspricht. Bei Anliegen eines Übersteuerungsanzeigesignals an der Leitung 66 wird der Multiplexer 62 derart geschaltet, das der Eingang 64 direkt mit dem Ausgang 67 des Multiplexers verbunden ist.

In dieser Schaltstellung wird der durch den Impulsgenerator 55 erzeugte Impuls lediglich durch die Erholzeit des Komparators 6 mittels des Laufzeitgliedes 57 verzögert. Hierdurch gibt die Beschleunigungsschaltung 19 über die Taktleitung 18 ein Taktsignal mit einer.kurzen Taktperiode ab, die der Erholungszeit bzw. Recoverytime des Komparators 6 entspricht.

Liegt umgekehrt an der Übersteuerungsanzeigesignalleitung 22 kein Übersteuerungsanzeigesignal an, dann schaltet der Multiplexer 62 in die entgegengesetzte Schaltstellung, d.h. der Eingang 61 wird mit dem Ausgang 67 verbunden.

Hierdurch werden die von dem Impulsgenerator 55 erzeugten Impulse durch beide Laufzeitglieder 57, 59 verzögert, wobei die Zeitverzögerung derart eingestellt wird, dass sie der notwendigen Entscheidungszeit des Komparators 6 entspricht. Hierdurch gibt die Beschleunigungsschaltung 19 über die Taktleitung 18 ein zweites Taktsignal mit einer langen Taktperiode an das sukzessive Approximationsregister 15 ab, wobei die lange Taktperiode der notwendigen Entscheidungszeit des Komparators 6 entspricht. Die Laufzeit der beiden Laufzeitglieder 57, 59 sind über die nicht dargestellt Einstellleitungen entsprechend einstellbar.

Tritt somit an einer der linearen Eingangsstufen 5, 12, des Komparators 6, eine Übersteuerung auf, wird die Taktfrequenz des Taktsignals zum Takten des sukzessiven Approximationsregisters 15 entsprechend erhöht und somit insgesamt die Konversionsrate des erfindungsgemäßen Analog-Digital-Wandlers 1 gesteigert. Dabei entspricht die Taktperiode des beschleunigten Taktsignals der Erholungszeit des Komparators 6 gegenüber aufgetretenen Übersteuerungen.

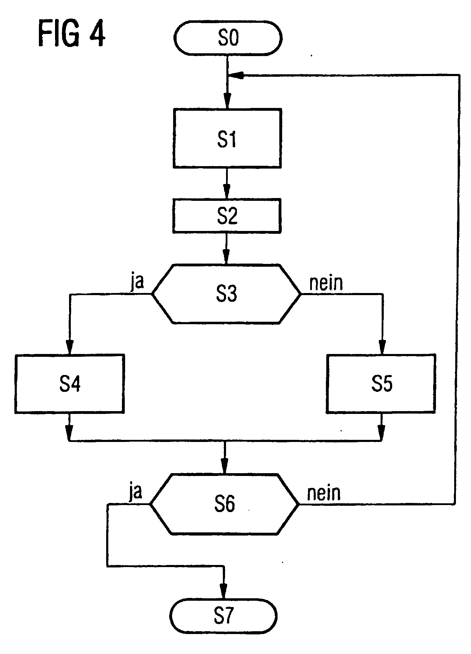

Figur 4 stellt ein Ablaufdiagramm des erfindungsgemäßen Verfahrens zur Umwandlung eines analogen Eingangssignals in ein digitales Ausgangssignal dar.

Nach einem Startschritt Sₒ wird im Schritt S 1 zunächst ein Bit digital gewandelt. Dabei beginnt man dann mit dem höchstwertigen Bit MSB.

In einem Schritt S 2 werden die Übersteuerungsanzeige durch die Beschleunigungsschaltung 19 eingelesen.

In einem Schritt S 3 wird entschieden, ob die lineare Eingangsstufe 5 des Komparators 6 übersteuert ist.

Falls im Schritt S 3 festgestellt wird, dass eine Übersteuerung der linearen Eingangsstufe 5 vorliegt, wird durch die Beschleunigungsschaltung 19 über die Leitung 18 ein Taktsignal an der sukzessive Approximationsregister 15 abgegeben, wobei die Taktperiode der Erholungszeit des Komparators 6 gegenüber einer Übersteuerung entspricht.

Wird umgekehrt im Schritt S3 festgestellt, dass keine Übersteuerung der linearen Eingangsstufe 5 vorliegt, gibt die Beschleunigungsschaltung 19 im Schritt S5 ein Taktsignal über die Taktsignalleitung 18 an das sukzessive Approximationsregister 15 ab, wobei die Taktperiode des Taktsignals der normalen notwendigen Entscheidungszeit des Komparators 6 entspricht.

Nach Durchführung der Schritte S4, S5 wird in einem Schritt S6 entschieden, ob bereits das niederwertigste Bit LSB gewandelt worden ist. Falls bereits das niederwertigste Bit gewandelt worden ist, wird der Ablauf im Schritt S7 beendet. Falls noch nicht das niederwertigste Bit gewandelt worden ist, kehrt der Ablauf zu Schritt S1 zurück.

Der in Figur 4 einfache dargestellte Ablauf kann erst kaskadenförmig erweitert werden, indem Übersteuerungsanzeigesignale von weiteren Eingangsstufen des Komparators 6 berücksichtigt werden. Es kann dabei bspw. die Übersteuerung der ersten und zweiten linearen Komparatoreingangsstufe ausgewertet werden. Ist die erste lineare Eingangsstufe 5 übersteuert, wird die Taktperiode stärker verkürzt als bei einem Betriebszustand, bei dem lediglich die zweite lineare Eingangsstufe 12 übersteuert wird.

Durch Auswertung der verschiedenen Übersteuerungsanzeigesignale der seriell hintereinandergeschalteten linearen Eingangsstufen 5,12, des Komparators 6 kann die Taktperiode des von der Beschleunigungsschaltung 19 an das sukzessive Approximationsregister 15 abgegebenen Taktsignals optimal eingestellt werden, so dass eine möglichst hohe Konversionsrate erreicht wird. Die Wandelzeit des Analog-Digital-Wandlers 1 kann je nach Auflösung des Analog-Digital-Wandlers 1 und je nach den Eigenschaften des Komparators 6 stark verkürzt werden.

Eine maximale Verkürzung der Wandelzeit kann dabei erreicht werden, indem die Auswertung der Übersteuerungsanzeigesignale durch die Beschleunigungsschaltung 19 auch zum Begrenzen der ersten linearen Komparatoreingangsstufe 5 bzw. zum Zurücksetzten des Komparators 6 verwendet wird. Hierdurch wird die Erholzeit nach einer erfolgten Übersteuerung minimiert.

Bei einem erfindungsgemäßen Verfahren wird das an dem analogen Signal Eingang 2 der anliegende zu wandelnde Eingangssignal mit dem an der Leitung 8 anliegenden Vergleichssignal verglichen, das einem in dem sukzessiven Approximationsregister 15 zwischengespeicherten Digitalwert entspricht. Der Komparator 6 bildet in Abhängigkeit von dem Vergleichsergebnis ein Komparatorausgangssignal Cₐᵤₛ zur Einstellung des zwischengespeicherten Digitalwertes in dem sukzessiven Approximationsregister 15. Die Beschleunigungsschaltung 19 erfasst über die Übersteuerungsanzeigesignalleitungen 22,23 , ob eine lineare Eingangsstufe 5,12 des Komparators 6 übersteuert ist. Wenn eine Übersteuerung durch die Beschleunigungsschaltung 19 erfasst wird, wird ein Taktsignal mit einer kurzen Taktperiode über die Taktsignalleitung 18 zum Takten des sukzessiven Approximationsregisters 15 abgegeben. Wenn umgekehrt, keine Übersteuerung durch die Beschleunigungsschaltung 19 erfasst wird, wird ein zweites Taktsignal mit einer relativ langen Taktperiode über die Taktsignalleitung 18 zum Takten des sukzessiven Approximationsregisters 15 abgegeben. Dabei entspricht die kurze Taktperiode der Erholungszeit des Komparators 6 gegenüber Übersteuerungen und die relativ lange Taktperiode der normalen notwendigen Entscheidungszeit des Komparators 6.
Während einer Wandlung wird nur bei einem einzigen Wägeschritt die volle Auflösung des Komparator 6 benötigt. Bei allen anderen Wägeschritten wird der Komparator 6 mehr oder weniger übersteuert, d. h. im Komparator wird ein Signal von mindestens einem LSB-Aussteurerung zu geführt. Die Erfassung der Übersteuerung muss an sich nicht besonders genau erfolgen. Dabei muss lediglich erfasst werden, ob eine Übersteuerung auftritt, nicht jedoch wie hoch diese Übersteuerung ist. Bei der Umwandlung tritt nur bei einem Bit die minimale Differenzspannung am Eingang des Komparators 6 auf. Bei allen weiteren Datenbits ist der Komparator 6 mehr oder weniger übersteuert, wobei der Digital-Analog-Wandler 9 letztendlich in LSB-Schritten bzw. Vielfachen davon schaltet.

### Bezugszeichenliste

- 1: Analog-Digital-Wandler
- 2: Analogeingang
- 3: Leitung
- 4: Differenzverstärkereingang
- 5: Lineare Eingangsstufe
- 6: Komparator
- 7: Differenzverstärkereingang
- 8: Leitung
- 9: Digital-Analog-Wandler
- 10: Leitung
- 11: Referenzspannungsanschluss
- 12: Lineare Eingangsstufe
- 13: Ausgangsstufe
- 14: Leitung
- 15: Sukzessives Approximationsregister
- 16: Takteingang
- 17: Taktleitung
- 18: Beschleunigungsschaltung
- 19: Taktleitung
- 20: Taktgenerator
- 21: Übersteuerungsanzeigeleitung
- 22: Übersteuerungsanzeigeleitung
- 23: Digitalleitung
- 24: Ausleseregister
- 26: Digitale Auslegeleitung
- 27,28: Differenzverstärker
- 29,30: Gateanschlüsse
- 31,32,: Leitungen
- 33,34: Lastwiderstände
- 35: Versorgungsanschluss
- 36: Stromquelle
- 37: Masseanschluss
- 38, 39: Erfassungstransistoren
- 40, 41: Gateanschlüsse
- 42, 43: Leitungen
- 44,45: Abzweigungsknoten
- 46: Stromquelle
- 47: Leitungen
- 48: Knoten
- 49: Stromquelle
- 50: Leitung
- 51: Knoten
- 52: Leitung
- 53: Leitung
- 54: Oder-Gatter
- 55: Impulsgenerator
- 56: Leitung
- 57: Laufzeitglied
- 58: Leitung
- 59: Laufzeitglied
- 60: Leitung
- 61: Multiplexer-Eingang
- 62: Multiplexer
- 63: Leitung
- 64: Eingang
- 65: Steueranschluss
- 66: Steuerleitung
- 67: Ausgang
- 68: Taktsignalleitung
- 69: Rückkoppelleitung

## Patentansprüche

1. Analog-Digital-Wandler zur sukzessiven approximierenden Umwandlung eines analogen Eingangssignals in ein digitales Ausgangssignal mit mindestens einem aus einer linearen Eingangstufe (5,12) und einer Ausgangsstufe (13) bestehenden Komparator (6), der das analoge Eingangssignal U_{E} einem von einem Digital-Analog-Wandler (9) abgegebenen analogen Vergleichssignal vergleicht und ein Komparatorausgangssignal Cₐᵤₛ zum Einstellen eines getakteten sukzessiven Approximationsregisters (15) abgibt, wobei der in dem sukzessiven Approximationsregister (15) zwischengespeicherte digitale Wert durch den Digital-Analog-Wandler (9) zu dem analogen Vergleichssignal gewandelt wird, und **gekennzeichnet durch** :
eine Beschleunigungsschaltung (19), die ein umschaltbares Taktsignal an das getaktete sukzessive Approximationsregister (15)in Abhängigkeit von mindestens einem Übersteuerungsanzeigesignal, das eine Übersteuerung einer zugehörigen linearen Eingangsstufe (5,12) in dem Komparator (6) anzeigt, abgibt.

2. Analog-Digital-Wandler nach Anspruch 1,
**dadurch gekennzeichnet,**
**dass** die linearen Eingangsstufen (5,12) jeweils eine Differenzverstärkerschaltung und eine Übersteuerungserfassungsschaltung zur Erfassung der Übersteuerung der Differenzverstärkerschaltung enthält.

3. Analog-Digital-Wandler nach Anspruch 1 oder 2,
**dadurch gekennzeichnet,**
**dass** die Übersteuerungserfassungsschaltung eine Fensterdiskriminatorschaltung ist.

4. Analog-Digital-Wandler nach einem der vorangehenden Ansprüche, **dadurch gekennzeichnet,**
**dass** die Beschleunigungsschaltung (19) mit einem Taktgenerator (21) verbunden ist.

5. Analog-Digital-Wandler nach einem der vorangehenden Ansprüche,
**dadurch gekennzeichnet,**
**dass** die Beschleunigungsschaltung (19) einen Impulsgenerator (55) aufweist, dem ausgangsseitig ein erstes Laufzeitglied zur Verzögerung des erzeugten Impulses um eine Zeit, die der Erholzeit des Komparators (6) entspricht, und ein zweites Laufzeitglied zur Verzögerung des erzeugten Impulses um eine Zeit, die der Entscheidungszeit des Komparators (6) entspricht, nachgeschaltet sind, wobei die Signalausgänge der beiden Laufzeitglieder (57,59) mit einer gesteuerten Schalteinrichtung (62) verbunden sind, die die Signalausgänge der beiden Laufzeitglieder (57,59) in Abhängigkeit von dem Übersteuerungsanzeigesignal an das sukzessive Approximationsregister (15) durchschaltet.

6. Analog-Digital-Wandler nach anspruch 5,
**dadurch gekennzeichnet,**
**dass** die Schalteinrichtung (62) ein Multiplexer ist.

7. Analog-Digital-Wandler nach Anspruch 5 oder 6,
**dadurch gekennzeichnet,**
**dass** der Impulsgenerator (55) ein D-Flip Flop ist.

8. Analog-Digital-Wandler nach anspruch 6,
**dadurch gekennzeichnet,**
**dass** der Ausgang des Multiplexer (67) an das D-Flip Flop (55) rückgekoppelt ist.

9. Analog-Digital-Wandler nach Anspruch 5 bis 8,
**dadurch gekennzeichnet,**
**dass** der Impulsgenerator (55) und die Laufzeitglieder (57,59) synchron durch den Taktgenerator (21) getaktet werden.

10. Analog-Digital-Wandler nach einem der vorangehenden Ansprüche,
**dadurch gekennzeichnet,**
**dass** das sukzessive Approximationsregister (15) mit einem Ausleseregister (25) zum Auslesen des digitalisierten Endwertes verbunden ist.

11. Analog-Digital-Wandler nach einem der vorangehenden Ansprüche,
**dadurch gekennzeichnet,**
**dass** die Übersteuerungserfassungsschaltung die Höhe und das Vorzeichen der Übersteuerung des Differenzverstärkers erfasst.

12. Analog-Digital-Wandler nach einem der vorangehenden Ansprüche,
**dadurch gekennzeichnet,**
**dass** das Taktsignal durch die Beschleunigungsschaltung (19) zwischen einem ersten Taktsignal mit einer kurzen Taktperiode und einem zweiten Taktsignal mit einer langen Taktperiode umschaltbar ist.

13. Analog-Digital-Wandler nach Anspruch 12,
**dadurch gekennzeichnet,**
**dass** die kurze Taktperiode der Erholungszeit des Komparators (6) gegenüber Übersteuerungen und die lange Taktperiode der Entscheidungszeit des Komparators (6) entspricht.

14. Analog-Digital-Wandler nach anspruch 12,
**dadurch gekennzeichnet,**
**dass** die kurze Taktperiode als Laufzeit des ersten Laufzeitgliedes (57) und die lange Taktperiode als Laufzeit der beiden seriell hintereinandergeschalteten ersten beiden Laufzeitglieder (57,59) einstellbar ist.

15. Verfahren zur Umwandlung eines analogen Eingangssignals in ein digitales Ausgangssignal mit den folgenden Schritten:
(a) Vergleichen des analogen Eingangssignals U_{E} mit einem analogen Vergleichssignal, das einem in einem getakteten sukzessive Approximationsregister (15) zwischengespeicherten Digitalwert entspricht, durch einen Komparator (6);
(b) Bilden eines Komparatorausgangssignals C aus in Abhängigkeit von dem Vergleichsergebnis zur Einstellung des zwischengespeicherten Digitalwertes in dem sukzessiven Approximationsregister (15);
**gekennzeichnet durch**:
(c) Erfassen ob eine lineare Eingangsstufe (5,12,) des Komparators (6) übersteuert ist;
(d) Umschalten eines Taktsignals für das getaktete sukzessive Approximationsregister (15) auf ein erstes Taktsignal mit einer kurzen Taktperiode, wenn eine Übersteuerung erfasst wird, und auf ein zweites Taktsignal mit einer langen Taktperiode, wenn keine Übersteuerung erfasst wird.

## Claims

1. Analogue/digital converter for successive approximation conversion of an analogue input signal into a digital output signal having at least one comparator (6), comprising a linear input stage (5, 12) and an output stage (13), which compares the analogue input signal U_{E} with an analogue comparison signal output by a digital/analogue converter (9) and outputs a comparator output signal Cₒᵤₜ for setting a clocked successive approximation register (15), the digital value buffer-stored in the successive approximation register (15) being converted by the digital/analogue converter (9) to form the analogue comparison signal, and **characterized by**:
an acceleration circuit (19) which outputs a switchable clock signal to the clocked successive approximation register (15) on the basis of at least one overdrive indicator signal which indicates overdriving of an associated linear input stage (5, 12) in the comparator (6).

2. Analogue/digital converter according to Claim 1,
**characterized**
**in that** the linear input stages (5, 12) respectively contain a differential amplifier circuit and an overdrive detection circuit for detecting the overdriving of the differential amplifier circuit.

3. Analogue/digital converter according to Claim 1 or 2,
**characterized**
**in that** the overdrive detection circuit is a window discriminator circuit.

4. Analogue/digital converter according to one of the preceding claims,
**characterized**
**in that** the acceleration circuit (19) is connected to a clock generator (21).

5. Analogue/digital converter according to one of the preceding claims,
**characterized**
**in that** the acceleration circuit (19) has a pulse generator (55), downstream of whose output side there are a first delay element for delaying the generated pulse by a time which corresponds to the recovery time of the comparator (6) and a second delay element for delaying the generated pulse by a time which corresponds to the decision time of the comparator (6), the signal outputs of the two delay elements (57, 59) being connected to a controlled switching device (62) which connects the signal outputs of the two delay elements (57, 59) to the successive approximation register (15) on the basis of the overdrive indicator signal.

6. Analogue/digital converter according to Claim 5,
**characterized**
**in that** the switching device (62) is a multiplexer.

7. Analogue/digital converter according to Claim 5 or 6,
**characterized**
**in that** the pulse generator (55) is a D-type flip-flop.

8. Analogue/digital converter according to Claim 6,
**characterized**
**in that** the output of the multiplexer (67) is fed back to the D-type flip-flop (55).

9. Analogue/digital converter according to Claims 5 to 8,
**characterized**
**in that** the pulse generator (55) and the delay elements (57, 59) are clocked synchronously by the clock generator (21).

10. Analogue/digital converter according to one of the preceding claims,
**characterized**
**in that** the successive approximation register (15) is connected to a read register (25) for reading the digitized final value.

11. Analogue/digital converter according to one of the preceding claims,
**characterized**
**in that** the overdrive detection circuit detects the level and the arithmetic sign of the overdriving of the differential amplifier.

12. Analogue/digital converter according to one of the preceding claims,
**characterized**
**in that** the clock signal can be switched over by the acceleration circuit (19) between a first clock signal having a short clock period and a second clock signal having a long clock period.

13. Analogue/digital converter according to Claim 12,
**characterized**
**in that** the short clock period corresponds to the recovery time of the comparator (6) with regard to overdriving, and the long clock period corresponds to the decision time of the comparator (6).

14. Analogue/digital converter according to Claim 12,
**characterized**
**in that** the short clock period can be set as the delay of the first delay element (57), and the long clock period can be set as the delay of the two delay elements (57, 59) connected in series one behind the other.

15. Method for converting an analogue input signal into a digital output signal, having the following steps:
(a) the analogue input signal U_{E} is compared with an analogue comparison signal, which corresponds to a digital value buffer-stored in a clocked successive approximation register (15), by a comparator (6);
(b) a comparator output signal Cₒᵤₜ is formed on the basis of the comparison result in order to set the buffer-stored digital value in the successive approximation register (15) ;
**characterized by**
(c) detection of whether a linear input stage (5, 12) of the comparator (6) is overdriven is effected;
(d) a clock signal for the clocked successive approximation register (15) is switched over to a first clock signal having a short clock period if overdriving is detected and to a second clock signal having a long clock period if no overdriving is detected.

## Revendications

1. Convertisseur analogique/numérique pour la conversion par approximation successive d'un signal d'entrée analogique en un signal de sortie numérique comprenant un comparateur (6) composé d'au moins un étage d'entrée linéaire (5, 12) et d'un étage de sortie (13) qui compare le signal d'entrée analogique U_{E} avec un signal de comparaison analogique délivré par un convertisseur numérique/analogique (9) et délivre un signal de sortie du comparateur Cₐᵤₛ pour régler un registre d'approximation successive cadencé (15), la valeur numérique enregistrée temporairement dans le registre d'approximation successive (15) étant convertie par le convertisseur numérique/analogique (9) en le signal de comparaison analogique, et **caractérisé par** un circuit d'accélération (19) qui délivre un signal d'horloge réversible au registre d'approximation successive cadencé (15) en fonction d'au moins un signal indicateur de saturation qui signale une saturation d'un étage d'entrée linéaire (5, 12) correspondant dans le comparateur (6).

2. Convertisseur analogique/numérique selon la revendication 1, **caractérisé en ce que** les étages d'entrée linéaire (5, 12) comprennent chacun un circuit amplificateur différentiel et un circuit de détection de saturation pour détecter la saturation du circuit amplificateur différentiel.

3. Convertisseur analogique/numérique selon la revendication 1 ou 2, **caractérisé en ce que** le circuit de détection de saturation est un discriminateur à fenêtre.

4. Convertisseur analogique/numérique selon l'une des revendications précédentes, **caractérisé en ce que** le circuit d'accélération (19) est relié à un générateur d'horloge (21).

5. Convertisseur analogique/numérique selon l'une des revendications précédentes, **caractérisé en ce que** le circuit d'accélération (19) présente un générateur d'impulsions (55) dont la sortie est connectée à une première bascule à retard pour retarder l'impulsion générée d'un temps qui correspond au temps de rétablissement du comparateur (6) et à une deuxième bascule à retard pour retarder l'impulsion générée d'un temps qui correspond au temps de décision du comparateur (6), les sorties signal des deux bascules à retard (57, 59) étant reliées à un dispositif de commutation commandé (62) qui interconnecte les sorties signal des deux bascules à retard (57, 59) avec le registre d'approximation successive (15) en fonction du signal indicateur de saturation.

6. Convertisseur analogique/numérique selon la revendication 5, **caractérisé en ce que** le dispositif de commutation (62) est un multiplexeur.

7. Convertisseur analogique/numérique selon la revendication 5 ou 6, **caractérisé en ce que** le générateur d'impulsions (55) est une bascule bistable.

8. Convertisseur analogique/numérique selon la revendication 6, **caractérisé en ce que** la sortie du multiplexeur (67) est rebouclée sur la bascule bistable (55).

9. Convertisseur analogique/numérique selon la revendication 5 à 8, **caractérisé en ce que** le générateur d'impulsions (55) et les bascules à retard (57, 59) sont cadencés de manière synchrone par le générateur d'horloge (21).

10. Convertisseur analogique/numérique selon l'une des revendications précédentes, **caractérisé en ce que** le registre d'approximation successive (15) est relié à un registre de lecture (25) pour lire la valeur finale numérisée.

11. Convertisseur analogique/numérique selon l'une des revendications précédentes, **caractérisé en ce que** le circuit de détection de saturation détecte le niveau et le signe de la saturation de l'amplificateur différentiel.

12. Convertisseur analogique/numérique selon l'une des revendications précédentes, **caractérisé en ce que** le circuit d'accélération (19) peut commuter le signal d'horloge entre un premier signal d'horloge ayant une période d'horloge courte et un deuxième signal d'horloge ayant une période d'horloge longue.

13. Convertisseur analogique/numérique selon la revendication 12, **caractérisé en ce que** la période d'horloge courte correspond au temps de rétablissement du comparateur (6) après des saturations et la période d'horloge longue au temps de décision du comparateur (6).

14. Convertisseur analogique/numérique selon la revendication 12, **caractérisé en ce que** la période d'horloge courte peut être réglée en tant que temps de propagation de la première bascule à retard (57) et la période d'horloge longue en tant que temps de propagation des deux bascules à retard (57, 59) branchées en série l'une derrière l'autre.

15. Procédé pour convertir un signal d'entrée analogique en un signal de sortie numérique comprenant les étapes suivantes :
(a) Comparaison par un comparateur (6) du signal d'entrée analogique U_{E} avec un signal de comparaison analogique qui correspond à une valeur numérique enregistrée temporairement dans un registre d'approximation successive cadencé (15) ;
(b) Formation d'un signal de sortie du comparateur Cₐᵤₛ en fonction du résultat de la comparaison en vue de régler la valeur numérique enregistrée temporairement dans le registre d'approximation successive (15) ;
**caractérisé par**
(c) La détection de la saturation éventuelle d'un étage d'entrée linéaire (5, 12) du comparateur (6) ;
(d) Le basculement d'un signal d'horloge pour le registre d'approximation successive cadencé (15) sur un premier signal d'horloge ayant une période d'horloge courte lorsqu'une saturation est détectée et sur un deuxième signal d'horloge ayant une période d'horloge longue lorsque aucune saturation n'est détectée.
